# EUROPÄISCHE PATENTSCHRIFT

(11) **EP 2 678 580 B1**
(45) Veröffentlichungstag und Bekanntmachung des Hinweises auf die Patenterteilung: **06.06.2018**
(21) Anmeldenummer: 13701054.2
(22) Anmeldetag: 21.01.2013
(51) Int. Cl.: F16F 1/373, G06F 1/18

(54) **STANDFUSS FÜR EIN COMPUTERGEHÄUSE SOWIE COMPUTERGEHÄUSE MIT EINEM DERARTIGEN STANDFUSS**
FOOT FOR A COMPUTER CASING, AND COMPUTER CASING HAVING A FOOT OF SAID TYPE
PIED DE SUPPORT POUR UN BOÎTIER D'ORDINATEUR AINSI QUE BOÎTIER D'ORDINATEUR POURVU D'UN TEL PIED DE SUPPORT

(30) Priorität: 30.01.2012 DE 102012100737
(43) Veröffentlichungstag der Anmeldung: 01.01.2014
(73) Patentinhaber: Fujitsu Technology Solutions Intellectual Property GmbH, 80807 München (DE)
(72) Erfinder: KANNLER, Bernhard, 86199 Augsburg (DE); SCHMID, Michael, 89407 Dillingen (DE)
(74) Vertreter: Epping - Hermann - Fischer
(86) Internationale Anmeldenummer: PCT/EP2013/051054
(87) Internationale Veröffentlichungsnummer: WO 2013/113582

(56) Entgegenhaltungen:
- US-A- 2 037 033
- US-A1- 2009 180 268
- US-A1- 2010 264 572

## Beschreibung

Die Erfindung betrifft einen Standfuß für Computergehäuse sowie ein Computergehäuse mit einem derartigen Standfuß.

Standfüße an einem Computergehäuse dienen sowohl zum stabilen Aufstellen des Computergehäuses auf einer Standfläche als auch zur Reduktion von Schwingungen und Schallwellen, welche durch Komponenten innerhalb des Computergehäuses erzeugt werden. Insbesondere rotierende Teile von Laufwerken oder Kühlvorrichtungen, wie Lüftern, erzeugen Schwingungen oder Vibrationen, welche sich in Form von Körperschall an mechanischen Verbindungen innerhalb des Computergehäuses und schließlich bis hin zu den Standfüßen an den äußeren Gehäusewandungen fortsetzen. Wenn dieser Körperschall von einem Standfuß auf die Standfläche für das Computergehäuse übertragen wird, erzeugt dies Störgeräusche.

Es existieren bereits Lösungen, Schwingungen, Vibrationen und resultierenden Körperschall durch ein oder mehrere Dämpfelemente zu reduzieren, wobei die Dämpfelemente an den Standfüßen angeordnet sind. Derartige Dämpfelemente sind beispielsweise aus einem elastischen Kunststoff gefertigt, wobei zumindest ein Teil des Computergehäuses derart mit den Dämpfelementen gekoppelt ist, dass Vibrationen und Schwingungen des Computergehäuses durch das Dämpfelement bedämpft werden können.

Derartige Dämpfelemente lösen eine Reduktion von Körperschall jedoch nur unzureichend, da andere Teile des Standfußes, welche mit dem Computergehäuse gekoppelt sind, Körperschall vom Computergehäuse über den Standfuß auf die Standfläche übertragen.

Aus der US 2,037,033 A ist ein vibrationsdämpfendes Gelenk bekannt, welches eine Wand, ein federndes Element, das sich lateral von der Wand in einen freien Raum erstreckt, und ein lateral federndes Element, welches sich von dem federnden Element in einem Abstand von der Wand erstreckt, umfasst.

Aus der US 2010/264572 A1 ist eine Dämpfer Baugruppe bekannt, welche ein Basiselement, ein oberes Element und einen Dämpfer aufweist, welcher zwischen das Basiselement und das obere Element platziert ist.

Aus der US 2009/180268 A1 ist ein Notebook-Computer bekannt, welcher eine Mehrzahl von Befestigungsbohrungen, die in eine Bodenfläche eingebracht sind, aufweist. Weiter weist der Notebook-Computer Fußplatten auf, welche durch die Befestigungsbohrungen an die Bodenfläche montiert sind.

Die Druckschriften DE 202007008416 U1, EP 0844838 B1, DE 19919302 A1 sowie US 5942735 A zeigen Standfüße, bei denen ein Basiselement zum Kontakt mit einer Standfläche und ein Befestigungselement zum Befestigen des Standfußes an einem Gerätegehäuse vermittels eines oder mehrerer Zwischenelemente mechanisch entkoppelt sind. Die Zwischenelemente können dabei vorteilhaft als Dämpfelemente wirken.

Der Nachteil der vorgenannten Lösungen besteht jedoch zum einen in einem relativ hohen konstruktiven Aufwand und zum anderen in einer im Wesentlichen nur axial wirkenden Dämpfung von mechanischen Schwingungen oder Vibrationen.

Es ist daher Aufgabe der Erfindung, einen Standfuß für ein Computergehäuse zu beschreiben, welcher eine verbesserte Reduktion von Schwingungen und Schallwellen sowohl in axialer als auch in radialer Richtung gewährleistet und zudem konstruktiv einfacher gestaltet ist als herkömmliche Lösungen.

Diese Aufgabe wird durch einen Standfuß der eingangs genannten Art gelöst, aufweisend ein Basiselement zum Kontakt mit einer Standfläche, ein Dämpfelement zum Dämpfen von Schwingungen und ein Befestigungselement zum Befestigen des Standfußes an einem Computergehäuse. Das Dämpfelement ist derart mechanisch zwischen dem Basiselement und dem Befestigungselement angeordnet, dass das Befestigungselement und das Basiselement mechanisch entkoppelt sind. Zudem ist das Dämpfelement ringförmig mit einem zentral angeordneten erhabenen Teilstück und einem daran anschließenden, sich radial nach außen erstreckendem Teilstück ausgeführt. Das Dämpfelement ist mit dem erhabenen Teilstück durch eine zentrale Öffnung des Befestigungselements geführt, sodass das Befestigungselement das Dämpfelement sowohl radial als auch axial kontaktiert. Das Basiselement ist ringförmig mit einem zentral angeordneten erhabenen Teilstück und einem daran anschließenden, sich radial nach außen erstreckendem Teilstück ausgeführt. Das Basiselement ist mit dem erhabenen Teilstück durch eine zentrale Öffnung des Dämpfelements geführt, sodass das Dämpfelement das Basiselement sowohl radial als auch axial kontaktiert. Ferner sind in Umfangsrichtung am erhabenen Teilstück des Dämpfelements axial verlaufende Stege ausgebildet, welche durch Nuten voneinander abgegrenzt sind. Die Stege sind auf dem sich radial nach außen erstreckendem Teilstück des Dämpfelements ebenfalls radial nach außen fortgesetzt, sodass das Dämpfelement an den Oberflächen der ausgebildeten Stege mit dem Befestigungselement kontaktiert. In einer Ausführungsform kontaktiert das Dämpfelement ausschließlich an den Oberflächen der ausgebildeten Stege mit dem Befestigungselement.

Ein derartiger Standfuß hat den Vorteil, dass die Befestigung des Standfußes an einem Computergehäuse und der Kontakt des Standfußes mit einer Standfläche durch zumindest zwei verschiedene Elemente bewerkstelligt werden. Mechanisch zwischen diesen Elementen ist zumindest ein Dämpfelement zum Dämpfen von Schwingungen und Vibrationen des Computergehäuses eingerichtet.

"Mechanisch entkoppelt" bedeutet hierbei, dass das Basiselement und das Befestigungselement des Standfußes nicht in unmittelbarem mechanischen Kontakt zueinander stehen. Insbesondere bedeutet dies, dass das Befestigungselement mit dem Dämpfelement und das Dämpfelement mit dem Basiselement in Kontakt steht, nicht jedoch das Basiselement mit dem Befestigungselement.

So können Schwingungen des Computergehäuses, welche Körperschall erzeugen, verbessert bedämpft werden, wobei die Schwingungen durch das Dämpfelement des Standfußes absorbiert oder unterbrochen werden, sodass sie sich nicht vom Computergehäuse über das Befestigungselement und schließlich hin zum Basiselement auf eine Standfläche fortsetzen können. Somit werden Störgeräusche, welche durch Vibrationen oder Schwingungen erzeugt werden, unterbunden.

"Axial" bedeutet in axialer Richtung, das heißt entlang einer Hauptachse des Dämpfelements. "Radial" bedeutet in radialer Richtung, das heißt in Richtung von der Hauptachse radial nach außen. In einer Ausführungsform kontaktiert das Befestigungselement das Dämpfelement am erhabenen Teilstück des Dämpfelements in axialer Richtung und am sich radial nach außen erstreckenden Teilstück in radialer Richtung.

Auf diese Weise können Schwingungen über das Dämpfelement absorbiert werden, welche sich sowohl in axialer wie auch in radialer Richtung vom Computergehäuse über das Befestigungselement entlang des Standfußes ausbreiten. Somit kann eine verbesserte Absorption beziehungsweise Dämpfung von Schwingungen erzielt werden. Vorteilhaft werden Schwingungen sowohl in axialer wie auch in radialer Richtung durch das Dämpfelement, welches beispielsweise elastisch ausgeführt sein kann, derart bedämpft, dass die Schwingungen sich nicht am Basiselement des Standfußes auf die Standfläche fortsetzen können.

Durch die Ausführung der Stege am Dämpfelement, welche durch Nuten voneinander abgegrenzt sind, wird die Auflagefläche des Befestigungselements am Dämpfelement in eine Vielzahl von Teilauflageflächen aufgeteilt. Aufgrund der Unterbrechung der Kontaktierung des Befestigungselements mit dem Dämpfelement durch die Stege wird die Kontaktfläche zwischen Befestigungselement und Dämpfelement sowohl axial als auch radial reduziert. Dies hat zur Folge, dass auch die Übertragung von Schwingungen vom Befestigungselement an das Dämpfelement in axialer wie in radialer Richtung reduziert werden kann. Schwingungen werden lediglich an den Kontaktflächen der Stege vom Befestigungselement an das Dämpfelement übertragen und können direkt an den Stegen des Dämpfelements bedämpft werden.

Ferner wird über die Stege des Dämpfelements, welche voneinander abgegrenzt sind, eine Unterbrechung einer Schwingungsübertragung vom Befestigungselement an das Dämpfelement entlang des Umfangs des Dämpfelements erreicht. Schwingungen können sich nicht entlang des Umfangs des Dämpfelements ausbreiten, da die Stege des Dämpfelements durch die Nuten voneinander abgegrenzt sind.

Auf diese Weise kann verhindert werden, dass Schwingungen des Befestigungselements derart auf das Dämpfelement übertragen werden, dass das Dämpfelement über seine gesamte Oberfläche in Schwingung gerät. Vielmehr werden Schwingungen des Befestigungselements gezielt an den Stegen des Dämpfelements sowohl absorbiert als auch durch die genannte Anordnung der Stege mit dazwischenliegenden Nuten in ihrer Ausbreitung unterbrochen.

Ein weiterer Vorteil der Ausführung von Stegen am Dämpfelement mit dazwischenliegenden Nuten besteht darin, dass die einzelnen Stege sowohl in axialer als auch in radialer Richtung als auch in Umfangsrichtung am Dämpfelement elastisch verformbar sind und Schwingungen des Befestigungselements aufnehmen können, ohne diese Schwingungen unmittelbar an weitere Wandungen des Dämpfelements weiterzugeben.

Das bedeutet, dass im Wesentlichen das Dämpfelement in radialer Richtung von einer Kontaktfläche mit dem Befestigungselement hin zu einer Hauptachse beziehungsweise von einer Kontaktfläche mit dem Befestigungselement in axialer Richtung entlang der Hauptachse eine Dämpfung von Schwingungen durchführt. Die Stege des Dämpfelements nehmen an den Kontaktflächen mit dem Befestigungselement Schwingungen auf und werden selbst zumindest teilweise zu Schwingungen angeregt, wobei die Schwingungen hin zu den durchgehend ausgeführten Bereichen (ohne Stege) sowohl des erhabenen Teilstücks wie auch des sich radial nach außen erstreckenden Teilstücks des Dämpfelements derart gedämpft werden, dass das Dämpfelement in den durchgehenden Bereichen im Wesentlichen schwingungsfrei ist.

Bevorzugt weist das Befestigungselement einen ringförmigen Grundkörper und in Umfangsrichtung am Grundkörper angeordnete und vom Grundkörper fortweisende Rastelemente zum Verrasten mit Gegenrastelementen an einem Computergehäuse auf. In einer Ausführungsform kontaktiert das Befestigungselement lediglich über die erläuterten Rastelemente mit Gegenrastelementen am Computergehäuse. Der Grundkörper des Befestigungselements steht somit nicht über seinen gesamten Umfang mit dem Computergehäuse in mechanischem Kontakt, sondern lediglich an vereinzelten Kontaktstellen, welche über die vom Grundkörper fort weisenden Rastelemente gebildet sind.

Auf diese Weise kann eine Kontaktfläche zwischen dem Befestigungselement des Standfußes und einem Computergehäuse reduziert werden, sodass eine Übertragung von Schwingungen vom Computergehäuse an den Standfuß ebenfalls vermindert wird.

Beispielsweise können die Rastelemente als Vorsprünge am Grundkörper des Befestigungselements angeformt sein, wobei Gegenrastelemente an einem Computergehäuse beispielsweise als Durchbrüche in einer Gehäusewandung des Computergehäuses ausgeführt sind. Die Rastelemente des Befestigungselements können dann durch die Durchbrüche hindurch tauchen. Es ist jedoch auch denkbar, dass die Rastelemente in Form von Schrauben, Nieten, etc. gebildet sind, wobei die Gegenrastelemente an einem Computergehäuse entsprechende Gegenstücke, wie Bohrungen, etc. bilden.

In einer Ausführungsform sind alle drei Elemente des Standfußes, Befestigungselement, Dämpfelement und Basiselement, gestaffelt angeordnet. Dabei liegt das Befestigungselement an einer Außenseite am Umfang des Dämpfelements an, wobei das Basiselement an einer gegenüberliegenden Innenseite des Dämpfelements in die zentrale Öffnung des Dämpfelements eintaucht. Auf diese Weise ist das Dämpfelement mechanisch zwischen dem Basiselement und dem Befestigungselement angeordnet, sodass Basiselement und Befestigungselement mechanisch entkoppelt sind, das heißt nicht in direktem mechanischen Kontakt zueinander sind.

In einer Ausführungsform ist das erhabene Teilstück des Basiselements durch mehrere Segmente gebildet, welche durch axial verlaufende Nuten voneinander getrennt sind. Alternativ oder ergänzend dazu sind an dem sich radial nach außen erstreckenden Teilstück des Basiselements ebenfalls in radialer Richtung Stege ausgebildet. Bevorzugt kontaktiert das Basiselement ausschließlich an den Oberflächen der Segmente und/oder der ausgebildeten Stege mit dem Dämpfelement. Das bedeutet, dass auch zwischen Dämpfelement und Basiselement die Kontaktfläche reduziert ist, sodass eine Schwingungsübertragung ebenfalls reduziert wird. Die Stege am Basiselement haben eine ähnliche Funktion wie die Stege am Dämpfelement (siehe obige Erläuterungen).

Durch die Segmentierung des erhabenen Teilstücks des Basiselements beziehungsweise durch die Ausbildung von Stegen am sich radial nach außen erstreckenden Teilstück des Basiselements wird zudem erreicht, dass eine mögliche Schwingungsübertragung zwischen dem Dämpfelement und dem Basiselement in Umfangsrichtung am Basiselement unterbrochen wird.

Die Ausführung des erhabenen Teilstücks des Basiselements in Form mehrerer Segmente, welche axial durch Nuten voneinander getrennt sind, hat ferner den Vorteil, dass das erhabene Teilstück des Basiselements flexibel anpassbar ist an eine Formgebung der zentralen Öffnung des Dämpfelements in die das Basiselement mit dem erhabenen Teilstück eintaucht. Insbesondere kann das Basiselement durch die Segmente klemmend am Dämpfelement festgelegt werden.

Vorzugsweise ist das Dämpfelement derart am Basiselement angeordnet, dass die Stege auf dem sich in radialer Richtung erstreckenden Teilstück des Dämpfelements horizontal versetzt zu den Stegen an dem sich in radialer Richtung erstreckenden Teilstück des Basiselements angeordnet sind. Das bedeutet, dass die Stege des Dämpfelements und die Stege des Basiselements nicht in Deckung zueinander angeordnet sind, sondern bewusst versetzt zueinander angeordnet sind.

Auf diese Weise ergibt sich eine örtliche Verteilung von Kontaktflächen sowohl zwischen dem Befestigungselement und dem Dämpfelement als auch zwischen dem Dämpfelement und dem Basiselement. Auf diese Weise wird verhindert, dass eine Kontaktfläche des Befestigungselements am Dämpfelement mit einer Kontaktfläche des Dämpfelements am Basiselement horizontal überlappt. Das bedeutet, dass Schwingungen, welche sich in axialer Richtung vom Befestigungselement auf das Dämpfelement übertragen, in Richtung des Basiselements ins Leere laufen und sich in axialer Richtung nicht weiter auf das Basiselement übertragen können. Somit wird auch auf diese Weise eine Schwingungsübertragung zwischen dem Befestigungselement und dem Basiselement mittels des Dämpfelements sowie durch die charakteristische Formgebung des Dämpfelements und des Basiselements und deren Anordnung zueinander erheblich reduziert beziehungsweise unterbunden.

Bevorzugt sind sowohl das Dämpfelement als auch das Basiselement aus einem umweltverträglichen Kunststoff ohne flammhemmenden Zusatzstoff gefertigt. Sowohl das Dämpfelement als auch das Basiselement genügen vorteilhaft den so genannten UL94-Anforderungen (Vorschrift UL94: "Tests for flammability of plastic materials for parts in devices and applications" der Underwriters Laboratories).

Insbesondere erlaubt die Ausführung des Standfußes der oben erläuterten Art mit dem Basiselement, dem Dämpfelement und dem Befestigungselement, wobei das Dämpfelement zwischen dem Basiselement und dem Befestigungselement angeordnet ist und lediglich das Befestigungselement mit dem Computergehäuse in direktem mechanischen Kontakt steht, den Einsatz von Materialien für das Dämpfelement beziehungsweise das Basiselement, welche der UL94-HB-Klassifizierung (HB = horizontal burning) genügen. Im Gegensatz zu Materialien, welche bei herkömmlichen Standfüßen für Computergehäuse eingesetzt werden, teilweise in das Computergehäuse hineinragen und strengeren Anforderungen - mindestens der UL94-V2-Klassifizierung (V2 = vertical burning) - genügen müssen, erlauben UL94-HB-Materialien einen flexibleren Einsatz in einem Standfuß eines Computergehäuses. Insbesondere können UL94-HB-Materialien eingesetzt werden, welche umweltverträglich sind, weil diese Materialien beim hier erläuterten Standfuß nicht in das Computergehäuse hineinragen und keine beigefügten flammhemmenden Zusatzstoffe, beispielsweise auf Chlorbasis, erforderlich machen, welche umweltschädlich sind. Auf diese Weise ist der hier erläuterte Standfuß in Bezug auf die verwendeten Materialien für das Dämpfelement sowie das Basiselement sehr umweltschonend. Besonders vorteilhaft können Materialien auf Basis natürlicher Polymere eingesetzt werden.

Das Basiselement des hier erläuterten Standfußes kann beispielsweise aus einem stabilen beziehungsweise festen Kunststoffmaterial aus der Gruppe der Thermoplaste wie Polyoxylmethylen (POM), Polypropylen (PP), Polyamid (PA), oder ähnliches gebildet sein.

Das Dämpfelement des hier erläuterten Standfußes kann beispielsweise im Vergleich zum Material des Basiselements aus einem weicheren Material aus der Gruppe der Elastomere gebildet sein, um Schwingungen und Vibrationen zu absorbieren. Hierfür bieten sich beispielsweise synthetische Kautschukarten wie Ethylen-Propylen-Dien-Monomer (EPDM) oder Styrol-Butadin-Kautschuk (SBR) an.

Vorteilhaft ist ein Computergehäuse mit einem Standfuß der erläuterten Art ausgerüstet, wobei der Standfuß über das Befestigungselement am Computergehäuse festgelegt ist. Das Computergehäuse ist beispielsweise ein Gehäuse für einen Desktop-PC, Stand-Alone-PC, All-in-one-PC oder Mini-PC.

Insbesondere bei Ausführung des Standfußes mit einem ringförmigen Grundkörper des Befestigungselements, wobei in Umfangsrichtung am Grundkörper von diesem fortweisende Rastelemente angeordnet sind, weist das Computergehäuse vorteilhaft Durchbrüche zum Hindurchtreten der Rastelemente des Befestigungselements auf, wobei das Computergehäuse ansonsten im Bereich des Standfußes öffnungsfrei ist. Das bedeutet, dass das Computergehäuse insbesondere keine Öffnung aufweist, durch die Teile des Dämpfelements oder des Basiselements in das Computergehäuse hineinragen. Die einzige mechanische Verbindung des erläuterten Standfußes mit dem Computergehäuse wird über das Befestigungselement erzielt. Auch aufgrund dieser Konstruktionsweise ist es möglich, für das Dämpfelement und das Basiselement UL94-HB-konforme Materialien, wie oben erläutert, einzusetzen.

Der erläuterte Standfuß für ein Computergehäuse wird sowohl in den Unteransprüchen wie auch in der nachfolgenden Figurenbeschreibung anhand mehrerer Zeichnungen erläutert.

Es zeigen:
- Figur 1A: eine perspektivische Darstellung einer Anordnung eines Standfußes mit einem Teil eines Computergehäuses,
- Figur 1B: die Anordnung gemäß Figur 1A in einer weiteren Perspektive,
- Figur 2A: eine Seitenansicht der Anordnung gemäß den Figuren 1A und 1B im montierten Zustand,
- Figur 2B: eine Draufsicht auf die Anordnung gemäß Figur 2A,
- Figur 3A: eine erste Schnittdarstellung der Anordnung aus Figur 2A,
- Figur 3B: eine zweite Schnittdarstellung der Anordnung aus Figur 2A,
- Figur 3C: eine dritte Schnittdarstellung der Anordnung aus Figur 2A,
- Figur 4: eine schematisierte Darstellung einer Draufsicht auf Teile eines Standfußes und
- Figur 5: einen Teil eines Computergehäuses.

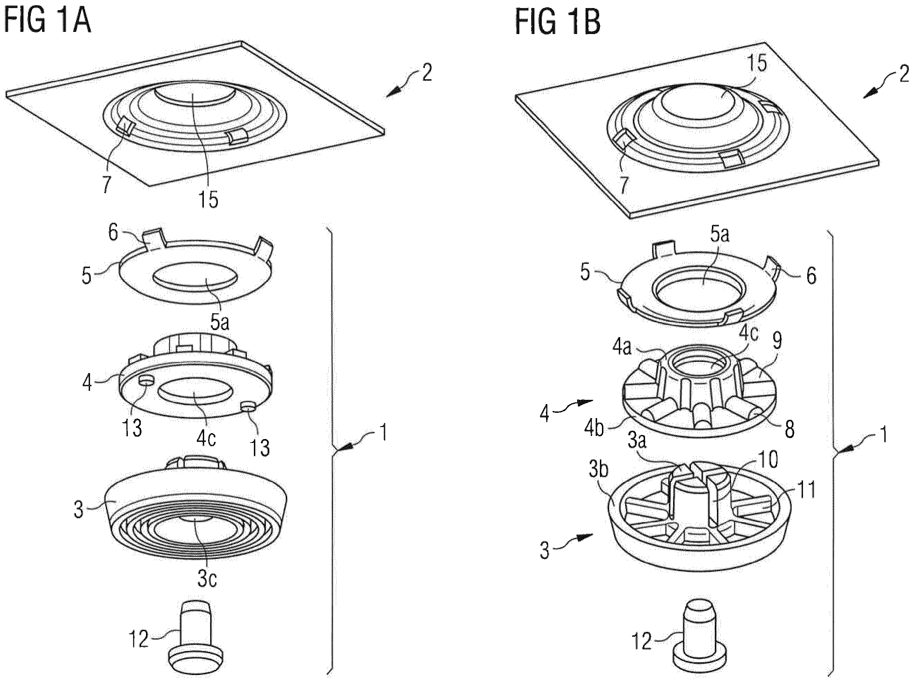

Figur 1A zeigt eine Anordnung mit einem Standfuß 1 und einem Teil eines Computergehäuses 2. Der Standfuß 1 umfasst mehrere Teile, welche derart ausgeführt und geformt sind, dass sie formschlüssig ineinander greifen und den Standfuß 1 bilden.

Insbesondere weist der Standfuß 1 (in der Anordnung von oben nach unten) ein Befestigungselement 5, ein Dämpfelement 4 sowie ein Basiselement 3 und schließlich ein Montageelement 12 auf. Das Befestigungselement 5 dient zum Befestigen des Standfußes 1 an einer Wandung des Computergehäuses 2. Das Dämpfelement 4 ist mechanisch zwischen dem Befestigungselement 5 und dem Basiselement 3 angeordnet und dient zur Dämpfung von Schwingungen des Computergehäuses 2. Das Basiselement 3 bildet den unteren Teil des Standfußes 1 in Richtung einer Standfläche und dient zum stabilen Kontakt eines Computergehäuses 2 über den Standfuß 1 mit der Standfläche.

Das Befestigungselement 5 weist einen ringförmigen Grundkörper mit einer zentral angeordneten Öffnung 5a auf. In Umfangsrichtung sind am Grundkörper des Befestigungselements 5 radial nach außen und vom Grundkörper fortweisende Rastelemente 6 angeordnet. In der in Figur 1A gezeigten Ausführungsform sind die Rastelemente 6 als Vorsprünge gebildet. Die Rastelemente 6 sind dazu eingerichtet, mit Gegenrastelementen 7 am Computergehäuse 2 zusammenzuwirken. Die Gegenrastelemente 7 sind in der dargestellten Ausführungsform in Form von Durchbrüchen in der Wandung des Computergehäuses 2 gebildet. Die Rastelemente 6 des Befestigungselements können in die Durchbrüche 7 eintauchen und das Befestigungselement 5 klammerartig am Computergehäuse 2 festlegen. Das Befestigungselement 5 kann beispielsweise aus Metall gefertigt sein.

Das Dämpfelement 4 ist ebenfalls ringförmig ausgebildet und weist eine zentrale Öffnung 4c auf. Das Dämpfelement 4 umfasst ein erhabenes Teilstück, welches zentral am Dämpfelement 4 angeordnet ist, und ein sich radial nach außen erstreckendes Teilstück. Das Dämpfelement 4 ist derart geformt, dass es mit dem erhabenen Teilstück durch die zentrale Öffnung 5a des Befestigungselements 5 hindurchtauchen kann.

Das Dämpfelement 4 kann beispielsweise aus einem Elastomer gefertigt sein und ist vorzugsweise derart flexibel, dass Vibrationen oder Schwingungen des Computergehäuses 2 durch das Dämpfelement 4 derart bedämpft werden, dass die Vibrationen sich nicht über den Standfuß 1 auf eine Standfläche übertragen können. Die Wirkweise des Dämpfelements 4 wird unten näher erläutert.

Auf der Unterseite des sich radial nach außen erstreckenden Teilstücks des Dämpfelements 4 sind Zentrierdorne 13 angeordnet, welche einer Positionierung des Dämpfelements 4 am Basiselement 3 dienen.

Das Basiselement 3 ist ebenfalls ringförmig mit einer zentralen Öffnung 3c ausgeführt. Ferner weist das Basiselement 3 ein erhabenes Teilstück und ein sich radial nach außen erstreckendes Teilstück auf. Das Basiselement 3 ist derart geformt, dass es mit dem erhabenen Teilstück in die zentrale Öffnung 4c des Dämpfelements eintauchen kann. Die Unterseite des sich radial nach außen erstreckenden Teilstücks des Basiselements 3 ist zur rutschfesten und stabilen Positionierung des Standfußes 1 auf einer Standfläche eingerichtet. Das Basiselement 3 kann beispielsweise aus einem stabilen Kunststoff aus der Gruppe der Thermoplaste gefertigt sein und eine widerstandsfähige und rutschfeste Unterseite des Standfußes 1 bilden.

Über ein Montageelement 12, welches im Ausführungsbeispiel stiftförmig ausgeführt ist, können das Basiselement 3, das Dämpfelement 4 und das Befestigungselement 5 im montierten Zustand aneinander festgelegt werden. Das Montageelement 12 kann ein Stift, eine Schraube, ein Nagel oder ähnliches sein.

Das Computergehäuse 2 weist im Bereich der Befestigung des Standfußes 1 eine Einbuchtung 15 auf, welche zu einer Innenseite des Computergehäuses 2 hin gewölbt ist. Aufgrund der Einbuchtung 15 kann die Anordnung des Standfußes 1 platzsparend am Computergehäuse 2 aufgenommen werden, sodass die Gesamtanordnung des Standfußes 1 am Computergehäuse 2 mit einer geringen Bauhöhe aufbaut. Das Computergehäuse 2 ist beispielsweise ein Gehäuse für einen Desktop-PC, Stand-Alone-PC, All-in-one-PC oder Mini-PC.

Ferner weist das Computergehäuse 2 lediglich Durchbrüche 7 zum Festlegen der Rastelemente 6 des Befestigungselements 5 auf (siehe obige Erläuterungen). Ansonsten ist das Computergehäuse 2 im Bereich des Standfußes 1 öffnungsfrei. Das bedeutet, dass die einzigen Öffnungen des Computergehäuses 2 durch die schmalen Durchbrüche 7 gebildet sind. Lediglich die Rastelemente 6 des Befestigungselements 5 ragen durch die Durchbrüche 7 teilweise in einen Innenraum des Computergehäuses 2 hinein. Weitere Teile des Standfußes 1, wie zum Beispiel das Dämpfelement 4 oder das Basiselement 3 haben im montierten Zustand weder einen direkten mechanischen Kontakt zum Computergehäuse 2 noch ragen sie durch Öffnungen in das Computergehäuse 2 hinein.

Die gestapelte oder gestaffelte Anordnung der Teile des Standfußes 1 hat den Vorteil, dass das Befestigungselement 5 und das Basiselement 3 im montierten Zustand (nicht gezeigt) mechanisch entkoppelt sind. Das bedeutet, dass das Befestigungselement 5 und das Basiselement 3 nicht in direktem mechanischen Kontakt zueinander stehen. Mechanisch zwischen dem Befestigungselement 5 und dem Basiselement 3 ist das Dämpfelement 4 angeordnet. Auf diese Weise können Schwingungen, welche beispielsweise durch rotierende Teile innerhalb des Computergehäuses 2 erzeugt und auf das Befestigungselement 5 übertragen werden, durch das Dämpfelement 4 derart gedämpft werden, dass eine weitere Schwingungsübertragung auf das Basiselement 3 und schließlich auf eine Standfläche reduziert beziehungsweise gänzlich unterbunden wird. Auf diese Weise werden Störgeräusche, welche durch Körperschall verursacht sind, reduziert oder unterbunden.

Die Ausführung und Anordnung der Teile des Standfußes 1 am Computergehäuse 2, insbesondere die Tatsache, dass im montierten Zustand weder das Dämpfelement 4 noch das Basiselement 3 in das Computergehäuse hineinragen, erlaubt zudem den Einsatz von Materialien für das Dämpfelement 4 und das Basiselement 3, welche aus umweltverträglichem Kunststoff ohne flammhemmenden Zusatzstoff gefertigt sind und dem UL94-HB-Standard entsprechen.

Figur 1B zeigt die Anordnung gemäß Figur 1A aus einer anderen Perspektive. Insbesondere verdeutlicht Figur 1B die konstruktive Ausführung des Dämpfelements 4 und des Basiselements 3.

Das Dämpfelement 4 umfasst, wie bereits erläutert, ein erhabenes Teilstück 4a und ein sich radial nach außen erstreckendes Teilstück 4b mit einer zentralen Öffnung 4c. Am erhabenen Teilstück 4a erstrecken sich in axialer Richtung Stege 8, welche sich am Teilstück 4b in radialer Richtung sternförmig nach außen fortsetzen. Die Stege 8 sind durch Nuten 9 voneinander abgegrenzt. Somit bilden die Stege 8 jeweils Erhöhungen am Grundkörper des Dämpfelements 4. Die Stege 8 bewirken, dass die Kontaktfläche des Befestigungselements 5 mit dem Dämpfelement 4 im montierten Zustand reduziert ist, sodass das Befestigungselement 5 lediglich an den Stegen 8 mit dem Dämpfelement 4 kontaktiert.

Ferner zeigt Figur 1B das Basiselement 3 mit einem erhabenen Teilstück 3a und einem sich radial nach außen erstreckenden Teilstück 3b. Das Teilstück 3a ist in Form von vier Segmenten gebildet, welche durch axiale Nuten 10 in Kreuzschlitzform voneinander abgegrenzt sind. Am Teilstück 3b sind Stege 11 ausgebildet, welche sich am Teilstück 3b sternförmig radial nach außen erstrecken. Die Segmente des erhabenen Teilstücks 3a und die Nuten 11 des Teilstücks 3b bewirken, dass die Kontaktfläche zwischen dem Dämpfelement 4 und dem Basiselement 3 im montierten Zustand reduziert wird. Das bedeutet, dass das Dämpfelement 4 mit seinem ringförmigen Grundkörper lediglich an den Segmenten des Teilstücks 3a und den Stegen 11 des Teilstücks 3b mit dem Basiselement 3 kontaktiert.

Aufgrund der Konstruktion des Dämpfelements 4 und des Basiselements 3 ist somit eine Mehrzahl von Kontaktflächen sowohl zwischen dem Befestigungselement 5 und dem Dämpfelement 4 als auch zwischen dem Dämpfelement 4 und dem Basiselement 3 gebildet. Aufgrund der Ausbildung von Stegen 8 und 11 am Dämpfelement 4 und am Basiselement 3 und einer Segmentierung des Teilstücks 3a am Basiselement 3 kann somit eine Ausbreitung von Schwingungen des Computergehäuses 2 über den Standfuß 1 sowohl in axialer als auch in radialer Richtung sowie in Umfangsrichtung unterbrochen beziehungsweise verhindert werden. Auf diese Weise werden sowohl Schwingungen des Computergehäuses 2 über das Dämpfelement 4 bedämpft, als auch die Ausbreitungsrichtung der Schwingungen vom Computergehäuse 2 entlang des Standfußes 1 in Richtung einer Standfläche unterbrochen.

Die Segmentierung des Teilstücks 3a des Basiselements 3 hat zudem noch eine weitere Funktion. Durch Einführen des stiftförmigen Montageelements 12 in die Öffnung 3a am Basiselement 3 (siehe Figur 1A) werden die Segmente des Teilstücks 3a radial nach außen gedrängt, sodass sie im montierten Zustand des Standfußes 1, das heißt bei gestapelter Anordnung der drei Elemente 3, 4 und 5, sowohl das Basiselement 3 klemmend am Dämpfelement 4 und gegebenenfalls auch das Dämpfelement 4 mittelbar klemmend am Basiselement 5 festlegen. Die Segmente des Teilstücks 3a drücken dann innerhalb der Öffnung 4c an die Innenwand des Dämpfelements 4.

Eine klemmende Verbindung zwischen Dämpfelement 4 und Befestigungselement 5 wird zudem dadurch erzielt, dass sich das erhabene Teilstück 4a des Dämpfelements 4 in Richtung des Teilstücks 4b in radialer Richtung verbreitert. Auf diese Weise kann das Befestigungselement 5 auf das Dämpfelement 4 aufgepresst werden und klemmend am Dämpfelement 4 festgelegt werden.

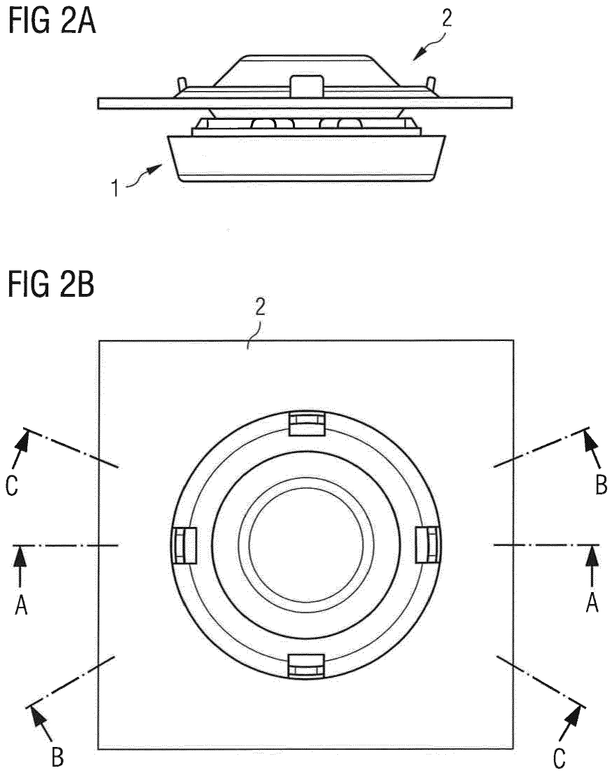

Figur 2A zeigt die Anordnung gemäß den Figuren 1A und 1B im montierten Zustand. Insbesondere veranschaulicht Figur 2A die platzsparende Unterbringung des Standfußes 1 am Computergehäuse 2.

Figur 2B zeigt eine Draufsicht der Anordnung gemäß Figur 2A, wobei unterschiedliche Schnitte durch die Anordnung am Computergehäuse 2 durch Schnittachsen A-A, B-B und C-C angedeutet sind, welche nachfolgend erläutert werden.

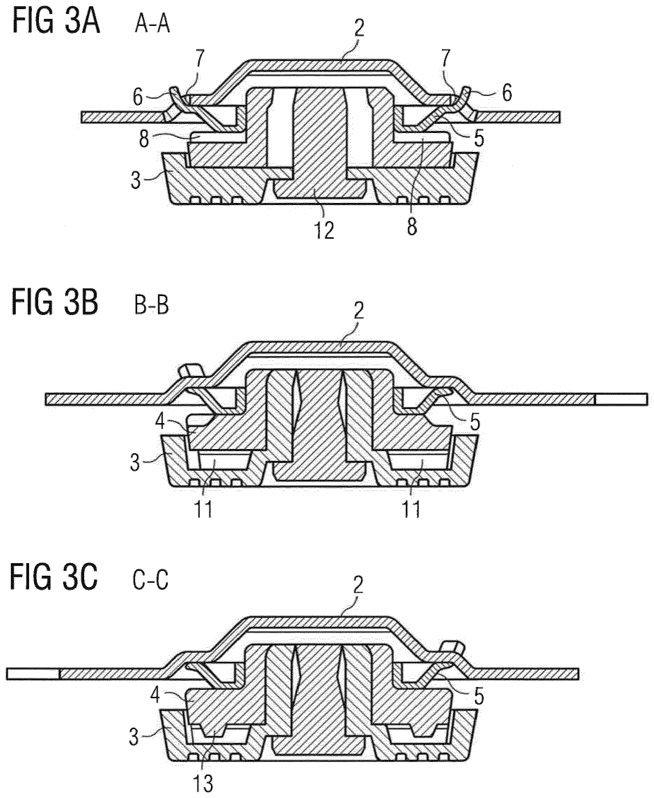

Figur 3A zeigt einen ersten Schnitt durch die Anordnung gemäß der Schnittachse A-A aus Figur 2B.

Figur 3A verdeutlicht die Festlegung des Standfußes 1 über die Rastelemente 6 am Computergehäuse 2, wobei die Rastelemente 6 durch Durchbrüche 7 am Computergehäuse 2 hindurchtauchen. Das Befestigungselement 5 legt den Standfuß somit über die Rastelemente 6 klammerartig am Computergehäuse 2 fest.

Ferner kontaktiert das Befestigungselement 5 das Dämpfelement 4 sowohl radial als auch axial. Insbesondere liegt das Befestigungselement 5 an Stegen 8 des Dämpfelements 4 auf, wie zu Figur 1B erläutert wurde.

Ferner kontaktiert das Dämpfelement 4 schließlich mit dem Basiselement 3. Über das Montageelement 12 werden die Elemente 3, 4 und 5 klemmend aneinander festgelegt.

Figur 3B zeigt eine zweite Schnittdarstellung gemäß einer Achse B-B aus Figur 2B. Figur 3B zeigt dabei insbesondere die Kontaktierung zwischen dem Dämpfelement 4 und dem Basiselement 3, wobei das Dämpfelement 4 an Stegen 11 des Basiselements 3 aufliegt.

Figur 3C zeigt eine dritte Schnittdarstellung gemäß einer Achse C-C aus Figur 2B. Figur 3C verdeutlicht eine Ausrichtung des Dämpfelements 4 am Basiselement 3 über Zentrierdorne 13 des Dämpfelements 4. Auf diese Weise kann das Dämpfelement 4 auf vorbestimmte Weise am Basiselement 3 festgelegt werden.

Die Figuren 3A bis 3C veranschaulichen eine radiale sowie axiale Kontaktierung des Befestigungselements 5 mit dem Dämpfelement 4. Dies hat den Vorteil, dass Schwingungen des Computergehäuses 2 sowohl in axialer als auch in radialer Richtung in das Dämpfelement 4 eingeleitet werden können und über das Dämpfelement 4 bedämpft werden können. Zudem bewirkt eine Kontaktierung zwischen dem Befestigungselement 5 und dem Dämpfelement 4 über Stege 8 und zwischen dem Dämpfelement 4 und dem Basiselement 3 über Stege 11 eine unterbrochene Kontaktierung der drei Elemente, sodass eine Ausbreitung von Schwingungen vom Befestigungselement 5 über das Dämpfelement 4 auf das Basiselement 3 weiter reduziert beziehungsweise gänzlich unterbunden wird.

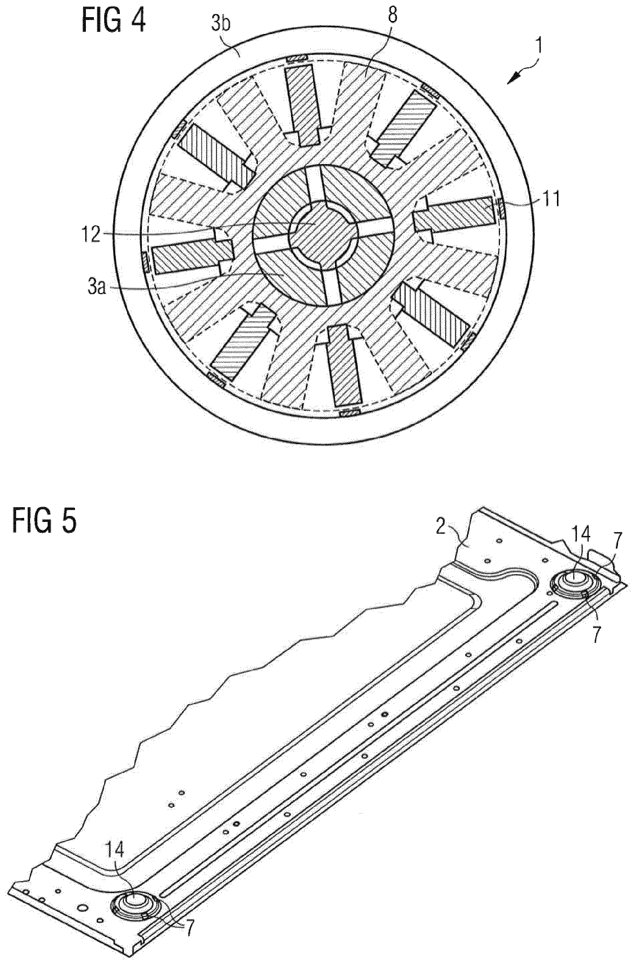

Figur 4 zeigt schematisiert eine Draufsicht auf das Dämpfelement 4 und das Basiselement 3, welche über das Montageelement 12 zusammengehalten werden.

Zur verbesserten Anschaulichkeit scheint das Dämpfelement 4 derart durchsichtig, dass eine versetzte Anordnung von Stegen 8 des Dämpfelements 4 und Stegen 11 am Teilstück 3b des Basiselements 3 veranschaulicht wird.

Die versetzte Anordnung der Stege 8 und 11 hat den Effekt, dass eine Kontaktierung des Befestigungselements 5 an Stegen 8 des Dämpfelements 4, wie oben erläutert, versetzt angeordnet ist zu einer Kontaktierung des Dämpfelements 4 mit Stegen 11 des Basiselements 3. Auf diese Weise können Schwingungen, welche vom Befestigungselement 5 auf das Dämpfelement 4 an den Stegen 8 übertragen werden, nicht unmittelbar an der gleichen Kontaktstelle auch auf die Stege 11 des Basiselements 3 übertragen werden. Somit wird eine Schwingungsübertragung gezielt unterbrochen.

Ähnliches wird durch die kreuzschlitzartige Segmentierung des Teilstücks 3a des Basiselements 3 erreicht, wobei eine Kontaktierung des Basiselements 3 mit dem Dämpfelement 4 im Bereich des Teilstücks 3a entsprechend unterbrochen ist, sodass entlang der Umfangsrichtung des Teilstücks 3a eine Schwingungsausbreitung vom Dämpfelement 4 an das Basiselement 3 unterbrochen wird.

Figur 5 zeigt schließlich einen Teil eines Computergehäuses 2 mit Bereichen 14, in denen Standfüße 1 der erläuterten Art an Gegenrastelementen 7 des Computergehäuses 2, hier in Form von Durchbrüchen, montiert werden können.

Die konstruktive Ausführung eines Standfußes 1 der erläuterten Art und dessen Anordnung an einem Computergehäuse 2 erlaubt eine gezielte Bedämpfung von mechanischen Schwingungen des Computergehäuses 2 sowohl in radialer als auch in axialer Richtung, sodass sich eine Schwingungsübertragung vom Computergehäuse 2 über den Standfuß 1 auf eine Standfläche gezielt reduzieren beziehungsweise unterbinden lässt. Dies reduziert die Erzeugung von Körperschall.

Zudem erlaubt die konstruktive Ausgestaltung eines Standfußes 1 eine gezielte Unterbrechung einer Ausbreitung von Schwingungen entlang des Standfußes 1 durch eine versetzte Kontaktierung der drei Elemente Befestigungselement 5, Dämpfelement 4 und Basiselement 3 des Standfußes 1. Auch auf diese Weise wird eine Schwingungsübertragung vom Computersystem 2 über den Standfuß 1 auf eine Standfläche reduziert beziehungsweise gänzlich unterbunden.

Zudem erlaubt die konstruktive Ausführung eines derartigen Standfußes 1, dessen Eindringen in das Computergehäuse 2 lediglich an einzelnen Kontaktpunkten eines Befestigungselements 5 hergestellt ist, den Einsatz von Materialien für das Dämpfelement 4 und das Basiselement 3, welche anstelle von strengen Anforderungen des UL94-V2-Standards lediglich den Anforderungen des UL94-HB-Standards genügen müssen. Dies erlaubt eine flexiblere Materialwahl für das Dämpfelement 4 und das Basiselement 3.

Das Dämpfelement 4 und das Basiselement 3 können bevorzugt derart austauschbar ausgeführt werden, dass sie in ihrer Dicke an unterschiedliche mechanische Anforderungen für ein Computergehäuse 2, insbesondere an unterschiedliches Gewicht eines Computergehäuses 2, angepasst werden können.

Sämtliche Darstellungen sind lediglich beispielhaft gewählt.

### Bezugszeichenliste

- 1: Standfuß
- 2: Computergehäuse
- 3: Basiselement
- 3a: erhabenes Teilstück am Basiselement
- 3b: radial nach außen weisendes Teilstück am Basiselement
- 3c: Öffnung am Basiselement
- 4: Dämpfelement
- 4a: erhabenes Teilstück am Dämpfelement
- 4b: radial nach außen weisendes Teilstück am Dämpfelement
- 4c: Öffnung am Dämpfelement
- 5: Befestigungselement
- 5a: Öffnung am Befestigungselement
- 6: Rastelemente des Befestigungselements
- 7: Gegenrastelemente am Computergehäuse
- 8: Stege am Dämpfelement
- 9: Nuten am Dämpfelement
- 10: axiale Nuten am Basiselement
- 11: Stege am Basiselement
- 12: Montageelement
- 13: Zentrierdorne
- 14: Bereich des Standfußes am Computergehäuse
- 15: Einbuchtung am Computergehäuse

## Patentansprüche

1. Standfuß (1) für ein Computergehäuse (2), aufweisend
- ein Basiselement (3) zum Kontakt mit einer Standfläche,
- ein Dämpfelement (4) zum Dämpfen von Schwingungen und
- ein Befestigungselement (5) zum Befestigen des Standfußes (1) an einem Computergehäuse (2),
wobei das Dämpfelement (4) derart mechanisch zwischen dem Basiselement (3) und dem Befestigungselement (5) angeordnet ist, dass das Befestigungselement (5) und das Basiselement (3) mechanisch entkoppelt sind,
wobei das Dämpfelement (4) ringförmig mit einem zentral angeordneten erhabenen Teilstück (4a) und einem daran anschließenden sich radial nach außen erstreckenden Teilstück (4b) ausgeführt ist und wobei das Dämpfelement (4) mit dem erhabenen Teilstück (4a) durch eine zentrale Öffnung (5a) des Befestigungselements (5) geführt ist, sodass das Befestigungselement (5) das Dämpfelement (4) sowohl radial als auch axial kontaktiert,
wobei das Basiselement (3) ringförmig mit einem zentral angeordneten erhabenen Teilstück (3a) und einem daran anschließenden sich radial nach außen erstreckenden Teilstück (3b) ausgeführt ist und das Basiselement (3) mit dem erhabenen Teilstück (3a) durch eine zentrale Öffnung (4c) des Dämpfelements (4) geführt ist, sodass das Dämpfelement (4) das Basiselement (3) sowohl radial als auch axial kontaktiert,
**dadurch gekennzeichnet, dass**
in Umfangsrichtung am erhabenen Teilstück (4a) des Dämpfelements (4) axial verlaufende Stege (8) ausgebildet sind, welche durch Nuten (9) voneinander abgegrenzt sind, und wobei die Stege (8) auf dem sich radial nach außen erstreckenden Teilstück (4b) des Dämpfelements (4) ebenfalls radial nach außen fortgesetzt sind, sodass das Dämpfelement (4) an den Oberflächen der ausgebildeten Stege (8) mit dem Befestigungselement (5) kontaktiert.

2. Standfuß (1) nach Anspruch 1, wobei das Befestigungselement (5) einen ringförmigen Grundkörper und in Umfangsrichtung am Grundkörper angeordnete und vom Grundkörper fort weisende Rastelemente (6) zum Verrasten mit Gegenrastelementen (7) an einem Computergehäuse (2) aufweist.

3. Standfuß (1) nach Anspruch 1 oder 2, wobei das erhabene Teilstück (3a) des Basiselements (3) durch mehrere Segmente gebildet ist, welche durch axial verlaufende Nuten (10) voneinander getrennt sind, und wobei an dem sich radial nach außen erstreckenden Teilstück (3b) des Basiselements (3) ebenfalls in radialer Richtung Stege (11) ausgebildet sind, sodass das Basiselement (3) an den Oberflächen der Segmente sowie der ausgebildeten Stege (11) mit dem Dämpfelement (4) kontaktiert.

4. Standfuß (1) nach Anspruch 3, wobei das Dämpfelement (4) derart am Basiselement (3) angeordnet ist, dass die Stege (8) auf dem sich in radialer Richtung erstreckenden Teilstück (4b) des Dämpfelements (4) horizontal versetzt zu den Stegen (11) an dem sich in radialer Richtung erstreckenden Teilstück (3b) des Basiselements (3) angeordnet sind.

5. Standfuß (1) nach Anspruch 3 oder 4, wobei ein stiftförmiges Montageelement (12) in eine zentrale Öffnung (3c) des Basiselements (3) eingeführt ist, sodass die Segmente des erhabenen Teilstücks (3a) des Basiselements (3) durch das Montageelement (12) radial nach außen gezwungen werden und das Dämpfelement (4) klemmend am Basiselement (3) festlegen.

6. Standfuß (1) nach einem der Ansprüche 1 bis 5, wobei sowohl das Dämpfelement (4) als auch das Basiselement (3) aus einem umweltverträglichen Kunststoff ohne flammhemmenden Zusatzstoff gefertigt sind.

7. Computergehäuse (2) mit einem Standfuß (1) nach einem der Ansprüche 1 bis 6, wobei der Standfuß (1) über das Befestigungselement (5) am Computergehäuse (2) festgelegt ist.

8. Computergehäuse (2) nach Anspruch 7 mit einem Standfuß (1), aufweisend die Merkmale des Anspruchs 2, wobei das Computergehäuse (2) Durchbrüche (7) zum Hindurchtreten der Rastelemente (6) des Befestigungselements (5) des Standfußes (1) aufweist und ansonsten im Bereich (14) des Standfußes (1) öffnungsfrei ist.

## Claims

1. Foot (1) for a computer casing (2), comprising
- a base element (3) for contact with a supporting area,
- a damping element (4) for the damping of oscillations, and
- a fastening element (5) for fastening the foot (1) on a computer casing (2),
wherein the damping element (4) is arranged between the base element (3) and the fastening element (5) mechanically in such a manner that the fastening element (5) and the base element (3) are mechanically decoupled,
wherein the damping element (4) is ring-shaped with a centrally-arranged raised portion (4a) and with a portion (4b) that connects thereto and extends radially outward, and wherein the damping element (4), with the raised portion (4a), is guided through a central opening (5a) of the fastening element (5), so that the fastening element (5) contacts the damping element (4) both in a radial and an axial manner,
wherein the base element (3) is ring-shaped with a centrally-arranged raised portion (3a) and with a portion (3b) that connects thereto and extends radially outward, and the base element (3) with the raised portion (3a), is guided through a central opening (4a) of the damping element (4), so that the damping element (4) contacts the base element (3) both in a radial and an axial manner,
**characterized in that**
axially-extending webs (8), separated from each other through grooves (9), are formed in a circumferential direction on the raised portion (4a) of the damping element (4), and wherein the webs (8) likewise continue radially-outwardly on the portion (4b) of the damping element (4) extending radially outward, so that the damping element (4) contacts the fastening element (5) on the surfaces of the formed webs (8).

2. Foot (1) according to claim 1, wherein the fastening element (5) comprises a ring-shaped basic body and latch elements (7) arranged in a circumferential direction on the basic body and directed away from the basic body to latch with counter latching elements (7) on a computer casing (2).

3. Foot (1) according to claim 1 or 2, wherein the raised portion (3a) of the base element (3) is formed by multiple segments, which are separated from each other by axially-extending grooves (10), and wherein on the radially-outwardly extending portion (3b) of the base element (3), also webs (11) are formed in a radial direction, so that the base element (3) (4) on the surfaces of the segments, as well as of the formed webs (11), contacts the damping element.

4. Foot (1) according to claim 3, wherein the damping element (4) is arranged on the base element (3) in such a manner that the webs (8) on the portion (4b) of the damping element (4) extending in the radial direction are arranged horizontally offset with respect to the webs (11) on the portion (3b) of the base element (3) extending in a radial direction.

5. Foot (1) according to claim 3 or 4, wherein a pin-shaped mounting element (12) is inserted into a central opening (3c) of the base element (3), such that the segments of the raised portion (3a) of the base element (3) are forced radially outward by the mounting element (12) and secure the damping element (4) in a clamping manner on the base element (3).

6. Foot (1) according to one of claims 1 to 5, wherein both the damping element (4) and the base element (3) are produced from an environmentally-compatible plastic material without a flame-retardant additive.

7. Computer casing (2) with a foot (1) according to one of claims 1 to 6, wherein the foot (1) is secured to the computer casing (2) by the fastening element (5).

8. Computer casing (2) according to claim 7, with a foot (1), comprising the features of claim 2, wherein the computer casing (2) comprises perforations (7) for the pass-through of the latching elements (6) of the fastening element (5) of the foot (1), and otherwise is free of openings in the region (14) of the foot (1).

## Revendications

1. Pied de support (1) pour un boîtier d'ordinateur (2), comprenant
- un élément de base (3) pour le contact avec une surface de pose,
- un élément amortisseur (4) pour amortir des oscillations et
- un élément de fixation (5) pour fixer le pied de support (1) à un boîtier d'ordinateur (2),
l'élément amortisseur (4) étant agencé mécaniquement entre l'élément de base (3) et l'élément de fixation (5) telle que l'élément de fixation (5) et l'élément de base (3) sont mécaniquement désaccouplés,
l'élément amortisseur (4) étant réalisé sous forme annulaire avec une partie en relief (4a) au centre et une partie se joindre à celle-ci et s'étendant radialement vers l'extérieur (4b), l'élément amortisseur (4) étant guidé avec la partie en relief (4a) à travers une ouverture centrale (5a) de l'élément de fixation (5) de sorte que l'élément de fixation (5) est en contact aussi bien radial qu'axial avec l'élément amortisseur (4),
l'élément de base (3) étant réalisé sous forme annulaire avec une partie en relief (3a) au centre et une partie se joindre à celle-ci et s'étendant radialement vers l'extérieur (3b), l'élément de base (3) étant guidé avec la partie en relief (3a) à travers une ouverture centrale (4c) de l'élément amortisseur (4) de sorte que l'élément amortisseur (4) est en contact aussi bien radial qu'axial avec l'élément de base (3),
**caractérisé en ce que**
des traverses (8) s'étendant axialement sont réalisées le long de la direction circonférentielle à la partie en relief (4a) de l'élément amortisseur (4), lesquelles traverses (8) sont définies les unes par rapport aux autres par des rainures (9), et les traverses se poursuivant sur la partie (4b) de l'élément amortisseur (4) s'étendant radialement vers l'extérieur, également dans la direction radiale vers l'extérieur, de sorte que l'élément amortisseur (4) est en contact sur les surfaces des traverses (8) formées avec l'élément de fixation (5).

2. Pied de support (1) selon la revendication 1, **caractérisé en ce que** l'élément de fixation (5) présente un corps principal annulaire et des éléments d'encliquetage (6) disposés au corps principal et s'éloignant du corps principal dans la direction circonférentielle pour un verrouillage avec des éléments de contre-encliquetage (7) sur un boîtier d'ordinateur (2).

3. Pied de support (1) selon l'une quelconque des revendications 1 ou 2, **caractérisé en ce que** la partie en relief (3a) de l'élément de base (3) est formée par plusieurs segments qui sont séparés les uns des autres par des rainures (10) qui s'étendent dans la direction axiale, des traverses (11) étant réalisées sur la partie (3b) de l'élément de base (3) s'étendant vers l'extérieur dans la direction radiale, également dans la direction radiale, de sorte que l'élément de base (3) sur les surfaces des segments ainsi que sur les surfaces des traverses formées (11) est en contact avec l'élément amortisseur (4).

4. Pied de support (1) selon la revendication 3, **caractérisé en ce que** l'élément amortisseur (4) est disposé sur l'élément de base (3) de sorte que les traverses (8) sont décalées horizontalement sur la partie (4b) s'étendant dans la direction radiale de l'élément amortisseur (4) par rapport aux traverses (11) sur la partie (3b) s'étendant dans la direction radiale de l'élément de base (3).

5. Pied de support (1) selon l'une quelconque des revendications 3 ou 4, **caractérisé en ce que** un élément de montage (12) sous forme de goupille est introduit dans une ouverture centrale (3c) de l'élément de base (3) de sorte que les segments de la partie en relief (3a) de l'élément de base (3) sont forcés par l'élément de montage (12) dans la direction radiale vers l'extérieur et fixent par serrage l'élément amortisseur (4) sur l'élément de base (3).

6. Pied de support (1) selon l'une quelconque des revendications 1 à 5, **caractérisé en ce que** l'élément amortisseur (4) ainsi que l'élément de base (3) sont fabriqués à base d'une matière plastique écologique et sans aucun additif retardateur de flamme.

7. Boîtier d'ordinateur (2), avec un pied de support (1) selon l'une quelconque des revendications 1 à 6, **caractérisé en ce que** le pied de support (1) est fixé sur le boîtier d'ordinateur (2) au moyen de l'élément de fixation (5).

8. Boîtier d'ordinateur (2) selon la revendication 7, avec un pied de support (1), présentant les caractéristiques de la revendication 2, le boîtier d'ordinateur (2) comprenant des orifices (7) pour y faire passer les éléments d'encliquetage (6) de l'élément de fixation (5) du pied de support (1) et ne présente, par ailleurs, aucune ouverture dans la zone (14) du pied de support (1).
